# EUROPEAN PATENT APPLICATION

(11) **EP 2 113 779 A1**
(43) Date of publication of application: **04.11.2009**
(21) Application number: 08290418.6
(22) Date of filing: 30.04.2008
(51) Int. Cl.: G01R 31/3185

(54) **Testable integrated circuit and integrated circuit test method**

(71) Applicant: NXP B.V., 5656 AG Eindhoven (NL)
(72) Inventor: The designation of the inventor has not yet been filed
(74) Representative: Williamson, Paul Lewis

(57) **Abstract**

An integrated circuit (100) and a test method are disclosed. The IC (100 comprises a plurality of interconnections (120); and a test arrangement comprising a test access port (170) and a shift register (130) comprising a plurality of cells (132), each coupled to a respective interconnection (120) via at least one signal driver (203, 204, 205), the test arrangement further comprising a further shift register (140) comprising a plurality of cells (142) each coupled to a control terminal of a respective one of said signal drivers (203, 204, 205). This facilitates automated DC parametric testing of the interconnects (120) by shifting appropriate configuration data into the shift register (130) and the further shift register (140) respectively.

## Description

The present invention relates to an integrated circuit (IC) comprising a plurality of interconnections and a test arrangement comprising a test access port and a shift register comprising a plurality of cells, each coupled to a respective interconnection via at least one signal driver.

The present invention further relates to a method for testing such an IC.

Before releasing an IC into the market, an IC must be tested to ensure that the IC does not produce any errors to avoid customer returns and occurrence of potentially dangerous situations caused by unexpected IC behavior, e.g. in application domains where the IC plays an integral part in controlling a device, e.g. a car or another vehicle. Different types of errors exist. For instance, a hard error is an error caused by a physical fault such as an open, short or bridging fault. A soft error may be caused by a deviation from an intended IC design parameter, and may only occur when the IC is brought into certain modes of operation, e.g. a high-frequency operational mode. Such errors are usually more difficult to detect. An example of such an error is the failure of an external interconnection of an IC to communicate the intended signal behavior at high frequencies. Such failures may occur when an IC interconnect, e.g. a bond pad or a pin, does not exhibit the intended signal response characteristics. Such characteristics can be defined in terms of response parameters to voltage and current stimuli.

A well-established test approach for testing IC interconnections is the IEEE 1149.1 standard, which is more commonly known as boundary scan test (BST). To this end, an IC is extended with a test arrangement including a boundary scan register which is located between the IC interconnections and the internals of the IC. In functional mode, this register is transparent such that the shift register cells do not influence the signals communicated between the IC internals and the interconnects. In a test mode, and in particular in response to the EXTEST instruction, the boundary scan register is used to communicate, i.e. provide or capture, test stimuli with the interconnects to test for the presence of interconnect faults. This test method is well-suited to detect hard errors in the interconnections, but is less suited to detect different types of parametric errors because the signal drivers that couple the shift register cells to the interconnects are kept in mode as defined in the IEEE 1149.1 standard.

In 'Testing SoC Interconnects for Signal Integrity Using Extended JTAG Architecture' by M.H. Tehranipour et al. in Trans. Computer-Aided Design of Integrated Circuits and Systems, 23(5):800--811, May 2004, a system-on-chip architecture is disclosed in which two interconnected cores each comprise a modified boundary scan chain that are capable of generating and receiving multiple-transition test patterns to test the signal integrity of high-speed interconnections.

US patent No. 6,586,921 discloses an IC that has a built-in circuit for testing direct current (DC) parameters of the input and output pins of the IC. The built-in circuit is arranged to periodically sample the pin voltage to determine the magnitude and direction of the current at the pin. The test stimuli for the pins may be provided using an IEEE 1149.1-compliant boundary scan register. In order to determine the different DC parameters of the pins, the respective pin drivers are responsive to a control signal modifier circuit that is arranged to provide a driver with appropriate control signals in response to a combination of test access port (TAP) controller signals such as SHIFT-DR, UPDATE-DR and dedicated signals such as a pad test enable signal and a fast clock signal for accelerating the test clock. However, this solution has the disadvantage that the IC requires substantial amounts of additional hardware including additional pins for providing the dedicated signals.

The present invention seeks to provide an IC for which the interconnect DC parameters can be determined using less dedicated hardware.

The present invention seeks to provide a method for testing the DC parameters of the interconnects of an IC, which requires less dedicated hardware on the IC.

According to a first aspect of the present invention, there is provided an integrated circuit comprising a plurality of interconnections such as bond pads or pins and a test arrangement comprising a test access port and a shift register comprising a plurality of cells, each coupled to a respective interconnection via at least one signal driver, the test arrangement further comprising a further shift register comprising a plurality of cells each coupled to a control terminal of a respective one of said signal drivers.

Hence, by shifting appropriate driver configuration data into the further shift register, the drivers between the interconnections and the cells of the shift register can be brought into any desired state, which facilitates the automated testing of different DC parameters of the interconnections using the driver appropriate configuration data and test stimuli for the interconnections.

At least some of the cells of the further shift register may be coupled to the control terminal of more than one driver to facilitate testing blocks of drivers in the same DC mode, thus reducing the amount of shift register cells required.

At least some further shift register cells may further be arranged to provide respective control signals to the same signal driver. This facilitates bringing a signal driver in all possible DC modes in case of a single signal driver being configurable by more than one control signal.

In an embodiment, the test access port further comprises an instruction register and decoding logic coupled to the instruction register for connecting the shift register to a test data input in response to the presence of a first dedicated instruction in the instruction register, and for connecting the further shift register to the test data input in response to the presence of a further dedicated instruction in the instruction register. By selecting the shift register and further shift register by means of dedicated instructions, the TAP controller of the test arrangement does not need to be modified. A test apparatus may be provided comprising the dedicated instructions to control the integrated circuit during testing.

In an embodiment, the test arrangement may be a boundary-scan compliant test arrangement.

According to a further aspect of the present invention, there is provided a method of testing an integrated circuit according to the present invention, the method comprising connecting an external tester to the interconnections; loading a first test pattern into the shift register; loading a further test pattern into the further shift register; and determining respective parameter values of the interconnections.

Such a method facilitates the automated testing of different DC parameters of the interconnections without requiring signal generating hardware for bringing the interconnect drivers into the required modes for measuring the DC parameters. Instead, the necessary driver configuration signals may be shifted into the further shift register in the form of a further test pattern.

In case of the interconnections being inputs, the method may further comprise providing the interconnections with respective stimuli from the external tester, and wherein the step of determining respective parameter values of the interconnections comprises capturing said values in respective cells of the shift register. This facilitates shifting out the test results via the test data output of the test access port.

In case of the interconnections being outputs, the step of loading a first test pattern into the shift register may comprise loading stimuli for the respective interconnections into the shift register, and the step of determining respective parameter values of the interconnections may comprise capturing said respective parameter values on the external tester. This facilitates shifting in the test stimuli via the test data input of the test access port.

In an embodiment, the test arrangement further comprises an instruction register coupled to decoding logic for coupling a selected shift register to the test access port, the method further comprising shifting a first instruction into the instruction register to connect the shift register to a test data input for loading the first test pattern into the shift register; and shifting a further instruction into the instruction register to connect the further shift register to the test data input for loading the further test pattern into the further shift register. This embodiment ensures that the various DC parameters may be generated without requiring additional hardware for generating the driver configuration signals from the TAP control signals.

Embodiments of the invention are described in more detail and by way of non-limiting examples with reference to the accompanying drawings, wherein
FIG. 1 schematically depicts an IC according to an embodiment of the present invention;
FIG. 2 schematically depicts an aspect of the inventive IC in more detail;
FIG. 3 schematically depicts a flowchart of an embodiment of the method of the present invention; and
FIG. 4 schematically depicts a flowchart of another embodiment of the method of the present invention.

It should be understood that the Figures are merely schematic and are not drawn to scale. It should also be understood that the same reference numerals are used throughout the Figures to indicate the same or similar parts.

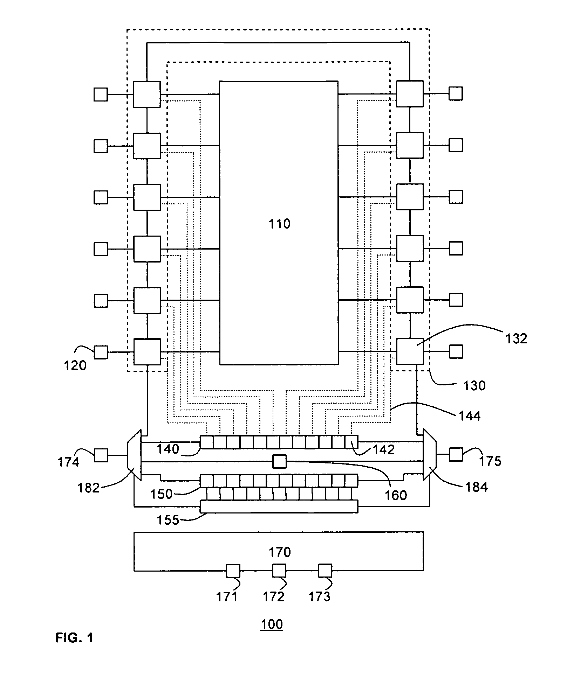

FIG. 1 depicts an IC 100 comprising a core 110. The core 110 is accessible through interconnects 120, e.g. bond pads or pins. The IC 100 further comprises a test arrangement including a TAP 170, which comprises a test data input (TDI) 174, a test data output (TDO) 175, a test mode select (TMS) input 171, a test clock (TCK) input 172 and a test reset (TRSTn) input 173. The test arrangement comprises a boundary scan shift register 130, with individual register cells 132 coupled between an interconnect 120 and the core 110. It is pointed out that although FIG. 1 shows a single boundary scan shift register cell 132 per interconnect 120, other configurations such as multiple boundary scan register cells 132 per interconnect 120 or interconnects 120 without boundary scan register cells in their connection to the core 110 are equally feasible.

The TAP 170, which may be a boundary scan test compliant TAP, further comprises an instruction register 150 coupled to decoding logic 155. The decoding logic 155 is responsible for decoding instructions that are shifted into the instruction register 150 e.g. during the SHIFT-IR mode of the state machine of the TAP controller (not shown), which are decoded for instance to provide selection signals for the input multiplexer 182 and the output multiplexer 184, which are arranged to connect selected shift registers to TDI 174 and TDO 175.

The test arrangement further comprises a further shift register 140, which has its register cells 142 coupled, via connections 144, to selected control terminals of respective signal drivers (not shown) between the boundary scan shift register cells 132 and the respective interconnects 120.

The TAP 170 may further comprise any other shift register such as a bypass register 160, or any other register which presence is mandated by the IEEE 1149.1 standard.

The decoding logic 155 is adapted to select the boundary scan register 130 in response to a dedicated instruction 'DC_PARAMETRIC', which allows for the shifting of a test pattern into the boundary scan register 130. This test pattern is comparable to a test pattern suitable for use in the EXTEST mode. The decoding logic 155 is further adapted to select the further scan register 140 in response to a dedicated instruction 'PAD_CONTROL', which allows for the shifting of a further test pattern into the further scan register 140. The further test pattern is defined to provide a set of control signals to the respective drivers between interconnects 120 and the boundary scan shift register 130 such that interconnects 120 can be driven into different DC modes, thus facilitating an automated DC parametric test of the interconnects 120.

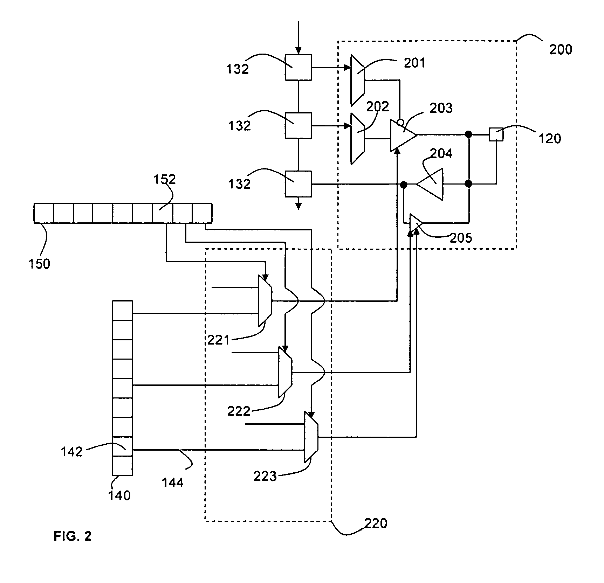

FIG. 2 shows an I/O cell of the integrated circuit 100 in more detail. In FIG. 2, the I/O cell 200 is a part of the boundary scan register 130. This, however, is not essential to the teachings of the present invention, and the I/O cell 200 may be a separate I/O cell. The I/O cell 200 comprises multiplexers 201, 202 responsive to the decoding logic 155 for connecting the boundary scan register cells 132 to the I/O cell 200 in response to instructions such as EXTEST and DC_PARAMETRIC.

The I/O cell 200 typically comprises a number of drivers, e.g. amplifying buffers, non-amplifying buffers and so on, for driving signals from and to the interconnect 120. In FIG. 2, the I/O cell comprises output signal drivers 203 and 205 and an input signal driver 204. In FIG. 2, the interconnect 120 is a bidirectional bond pad. However, it will be appreciated that the interconnect 120 may be an input or an output only, in which case the I/O cell 200 may be simplified. The specific embodiment of the I/O cell 200 is not essential to the present invention. The I/O cell 200 may be routinely modified by the skilled practitioner. Therefore, alternative embodiments of the I/O cell 200 are not further discussed for reasons of brevity only.

In accordance with the present invention, the drivers that can bring the interconnect 120 into different DC parametric modes are controlled by the further shift register 140. In FIG. 2, these are drivers 203 and 205. Selected further shift register cells 142 provide control signals ESH, P1 and P2 for the drivers of the I/O cell 200 via a configuration network 220. The configuration network 220, which may be implemented in any suitable way, e.g. by means of a plurality of multiplexers 221, 222, 223 under control of the decoding logic 155, is arranged to connect the control terminals of the drivers 203, 205 to the further shift register 140 in response to the dedicated instruction PAD_CONTROL. In the absence of this instruction, the configuration network 220 is configured to connect these control terminals to their functional mode controllers.

Table I gives an overview of the interconnect behavior that can be induced by the control signals P1, P2 and ESH:

**Table I**

| P1 | P2 | ESH | Interconnect behavior |
|---|---|---|---|
| 0 | 0 | X | Pull-down |
| 1 | 0 | X | Plain |
| 0 | 1 | X | Pull-up |
| 1 | 1 | X | Repeater |
| X | X | 0 | No hysteresis |
| X | X | 1 | Hysteresis |

The value X is a don't care value. This is because the state of the interconnect 120 caused by hysteresis driver 203 is not influenced by the pull-up/pull-down driver 205 and vice versa.

These signals can be used to generate the following industry standard DC parametric modes on an input interconnect 120: current input at low state (IIL), current input at high state (IIH), voltage input at low state (VIL), voltage input at high state (VIH). These signals can further be used to generate the following industry standard DC parametric modes on an output interconnect 120: current output at low state (IOL), current output at high state (IOH), high-impedance current output at low state (IOZL), high-impedance current output at high state (IOZH), voltage output at low state (VOL) and voltage output at high state (VOH). All states may be generated on a bidirectional interconnect 120.
Table II gives an overview of how the various parametric DC test modes can be invoked.

**Table II**

| DC mode | Input | Signal 201 | ESH | P1 | P2 |
|---|---|---|---|---|---|
| IIL | Low | 1 | X | 1 | 0 |
| IIH | High | 1 | X | 1 | 0 |
| VIL | Low | 1 | X | 1 | 0 |
| VIH | High | 1 | X | 1 | 0 |
| IOL | Low | 0 | 0/1 | 1 | 0 |
| IOH | High | 0 | 0/1 | 1 | 0 |
| IOZL | Low | 1 | X | 1 | 0 |
| IOZH | High | 1 | X | 1 | 0 |
| VOL | Low | 0 | 0/1 | 1 | 0 |
| VOH | High | 0 | 0/1 | 1 | 0 |
| PULL-UP | Low | 1 | X | 0 | 0 |
| PULL-DOWN | High | 1 | X | 0 | 1 |
| REPEAT | High/Low | 1 | X | 1 | 1 |

For different DC test modes having the same control signal configuration, the different modes are invoked by different signals provided by the ATE.

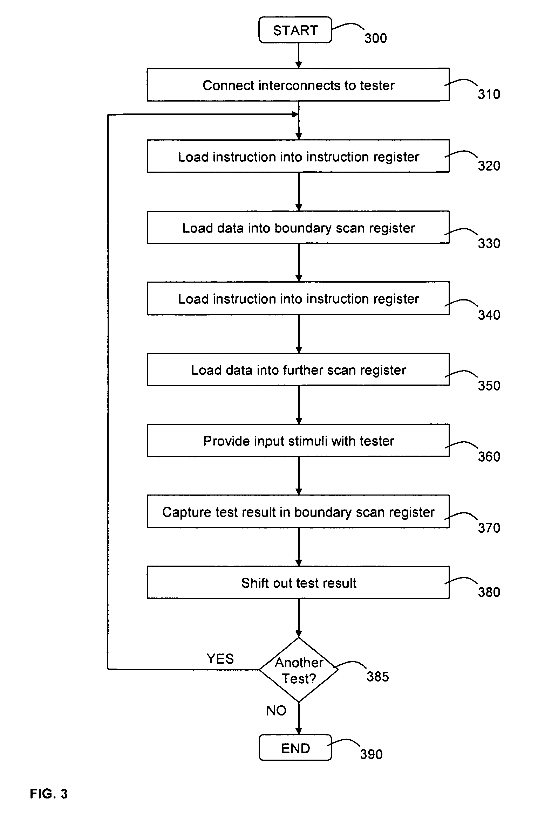

FIG. 3 depicts a flowchart of a method of the present invention in which a DC parametric mode of an interconnect 120 acting as an input is tested. Upon starting the method in step 300, automated test equipment (ATE) is brought into contact with the interconnects 120. This may for instance be achieved by means of probe needles, which may be grouped in a probe card. Next, the ATE brings the TAP controller of the IC 100 in a mode in which the instruction register 150 is arranged to receive the PAD_CONTROL instruction in step 320, which connects the further shift register 140 to TDI 174, after which the driver configuration data is shifted into the further shift register 140 in step 330.

In step 340, the instruction register 150 is again connected to TDI 174, and receives the instruction DC_PARAMETRIC, which connects the boundary scan shift register 130 to TDI 174, after which the boundary scan register 130 is loaded with the input data for the DC parametric test in step 350.

The interconnects 120 have now been brought into one of the DC parametric modes as previously explained. Next, in step 360, the ATE provides the interconnects with input stimuli, and the response to the input stimuli is captured in the boundary scan register 130 in step 370 and subsequently shifted out of the IC 100 via TDO 175 in step 380. In step 385, it is decided if another interconnect DC parameter is to be tested. If this is the case, the method may revert back to step 320; otherwise, the method terminates in step 390.

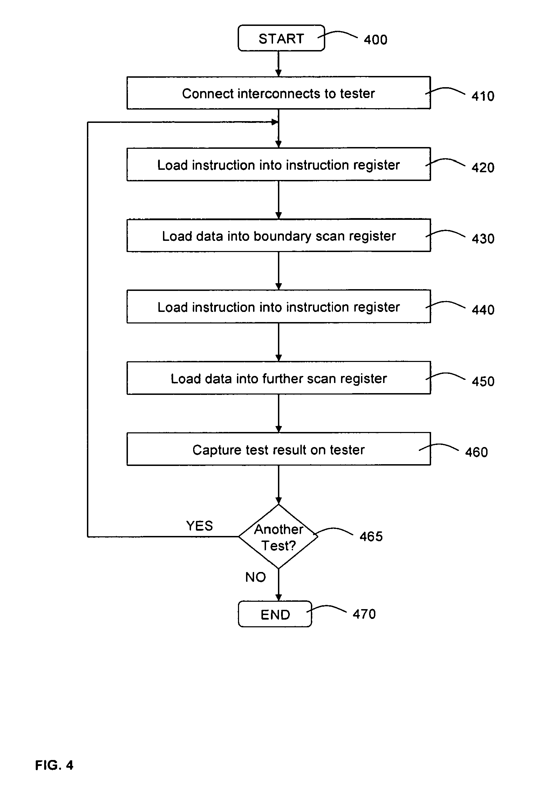

FIG. 4 depicts a flowchart of a method of the present invention in which a DC parametric mode of an interconnect 120 acting as an output is tested. Upon starting the method in step 400, automated test equipment (ATE) is brought into contact with the interconnects 410. Next, the ATE brings the TAP controller of the IC 100 in a mode in which the instruction register 150 is arranged to receive the PAD_CONTROL instruction in step 420, which connects the further shift register 140 to TDI 174, after which the driver configuration data is shifted into the further shift register 140 in step 430.

In step 440, the instruction register 150 is again connected to TDI 174, and receives the instruction DC_PARAMETRIC, which connects the boundary scan shift register 130 to TDI 174, after which the boundary scan register 130 is loaded with the input data for the DC parametric test in step 450.

The interconnects 120 have now been brought into one of the DC parametric modes as previously explained, with selected boundary scan register cells 132 providing the respective input stimuli for the interconnects 120 under test.

Next, in step 460, the ATE captures the response to the input stimuli, e.g. on the probe needles. In step 465, it is decided if another interconnect DC parameter is to be tested. If this is the case, the method may revert back to step 420; otherwise, the method terminates in step 470.

The test method of the present invention has several advantages over the state of the art. For instance, because all interconnects 120 can be simultaneously switched to a logic high, a logic low or a high-impedance state, the signal stabilization or settling time of the ATE prior to a DC parametric measurement is minimized, thus reducing the overall test time and cost. Moreover, setting up the DC parametric test can be done quickly simply by feeding the appropriate test patterns in the shift registers 130 and 140, which further reduces the overall test time. In addition, the automated approach of testing the DC parameters of the interconnects 120 obviates the need for manual testing, thus reducing the risk of human error.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. An integrated circuit (100) comprising:
a plurality of interconnections (120); and
a test arrangement comprising a test access port (170) and a shift register (130) comprising a plurality of cells (132), each coupled to a respective interconnection (120) via at least one signal driver (203, 204, 205), the test arrangement further comprising a further shift register (140) comprising a plurality of cells (142) each coupled to a control terminal of a respective one of said signal drivers (203, 204, 205).

2. An integrated circuit according to claim 1, further comprising a plurality of input/output cells (200), each comprising a cell (132) of the shift register (130) and the at least one signal driver (203, 204, 205) coupling said cell (132) to the respective interconnection (120).

3. An integrated circuit according to claim 1 or 2, wherein at least some further shift register cells (142) are arranged to provide respective control signals to the same signal driver (205).

4. An integrated circuit according to any of the preceding claims, wherein the test access port (170) further comprises an instruction register (150) and decoding logic (155) coupled to the instruction register for connecting the shift register (130) to a test data input (174) in response to the presence of a first dedicated instruction in the instruction register (150), and for connecting the further shift register (140) to the test data input (174) in response to the presence of a further dedicated instruction in the instruction register (150).

5. An integrated circuit according to claim 4, wherein said control terminals are coupled to the further shift register (140) via a configuration network (220) responsive to the decoding logic (155).

6. An integrated circuit according to claim 5, wherein the configuration network (220) comprises a plurality of multiplexers (221; 222; 223).

7. An integrated circuit according to any of the preceding claims, wherein the test arrangement is a boundary-scan compliant test arrangement.

8. An integrated circuit according to any of the preceding claims, wherein the interconnections (120) comprise bond pads.

9. A method of testing an integrated circuit comprising a plurality of interconnections (120) and a test arrangement comprising a test access port (170) and a shift register (130) comprising a plurality of cells (132), each coupled to a respective interconnection (120) via at least one signal driver (203, 204, 205), the test arrangement further comprising a further shift register (140) comprising a plurality of cells (142) each coupled to a control terminal of a respective one of said signal drivers (203, 204, 205), the method comprising:
connecting (310, 410) an external tester to the interconnections;
loading (320, 420) a first test pattern into the shift register;
loading (340, 440) a further test pattern into the further shift register; and
determining (370, 460) respective parameter values of the interconnections.

10. A method according to claim 9, further comprising providing (360) the interconnections with respective stimuli from the external tester, and wherein the step of determining respective parameter values of the interconnections (120) comprises capturing (370) said values in respective cells (132) of the shift register (130).

11. A method according to claim 9, wherein the step of loading a first test pattern into the shift register (130) comprises loading stimuli for the respective interconnections (120) into the shift register, and wherein the step of determining respective parameter values of the interconnections comprises capturing (460) said respective parameter values on the external tester.

12. A method according to any of claims 9-11, wherein the test arrangement further comprises an instruction register (150) coupled to decoding logic (155) for coupling a selected shift register to a test data input (174), the method further comprising:
shifting a first instruction into the instruction register (150) to connect the shift register (130) to the test data input (174) for loading the first test pattern into the shift register (130); and
shifting a further instruction into the instruction register (150) to connect the further shift register (140) to the test data input (174) for loading the further test pattern into the further shift register (140).

13. A test apparatus for testing the integrated circuit according to claim 4 or 5, wherein the test apparatus comprises the first dedicated instruction and the further dedicated instruction.
